## Europäisches Patentamt

## European Patent Office

## Office européen des brevets

(19)

(11) Numéro de publication: **0 060 761 B1**

(12) **FASCICULE DE BREVET EUROPEEN**

(45) Date de publication du fascicule du brevet:
31.07.85

(21) Numéro de dépôt: 82400388.3

(22) Date de dépôt: 05.03.82

(51) Int. Cl.⁴: **H 01 L 29/72**, H 01 L 29/10, H 01 L 29/60, H 01 L 29/62, H 01 L 21/285

(54) Transistor bipolaire latéral sur isolant et son procédé de fabrication.

(30) Priorité: **13.03.81 FR 8105130**

(43) Date de publication de la demande:
**22.09.82 Bulletin 82/38**

(45) Mention de la délivrance du brevet:
**31.07.85 Bulletin 85/31**

(84) Etats contractants désignés:
**DE FR GB NL**

(56) Documents cités:
**DE - A - 2 154 120**
**DE - A - 2 529 951**
**FR - A - 2 312 120**
**FR - A - 2 389 236**
**US - A - 3 513 042**
**US - A - 4 244 001**
**US - A - 4 259 680**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Mackowiak, Eugène, THOMSON-CSF SCPI 173, bld Haussmann, F-75360 Paris Cedex 08 (FR)**
Inventeur: **Borel, Joseph, THOMSON-CSF SCPI 173, bld Haussmann, F-75360 Paris Cedex 08 (FR)**
Inventeur: **Montier, Michel, THOMSON-CSF SCPI 173, bld Haussmann, F-75360 Paris Cedex 08 (FR)**

(74) Mandataire: **Guérin, Michel et al, THOMSON-CSF SCPI 173, Bld Haussmann, F-75379 Paris Cédex 08 (FR)**

## Description

La présente invention concerne un transistor bipolaire, NPN ou PNP, réalisé sur un substrat isolant et disposé latéralement, c'est à dire que l'émetteur, la base et le collecteur se succèdent horizontalement le long de la surface du substrat au lieu d'être disposés en pile comme dans un transistor vertical classique. De tels transistors sont par exemple connus des fascicules de brevet DE-A-2 529 951 et US-A-3 513 042.

L'intérêt de L'utilisation d'un transistor latéral est qu'il peut être fabriqué selon les mêmes étapes de procédé que des transistors à effet de champ (MOS) et que l'on peut donc réaliser sur un même substrat à la fois des transistors bipolaires et des transistors à effet de champ. Les transistors à effet de champ. Les transistors bipolaires serviront à la commande de puissance car ils peuvent laisser passer un courant beaucoup plus élevé que des transistors MOS de mêmes dimensions.

Des transistors MOS ont déjà été réalisés sur substrat isolant (par exemple en corindon). Il parait particulièrement intéressant d'appliquer cette idée aussi à des transistors bipolaires car la présence d'un substrat isolant en dessous de l'émetteur aura tendance à augmenter l'efficacité d'injection de porteurs de celui-ci en empêchant l'injection de porteurs dans d'autres directions que vers le collecteur.

Deux bonnes raisons existent donc pour vouloir réaliser un transistor bipolaire latéral sur isolant: avantages escomptés pour l'injection de courant et compatibilité technologique avec des transistors MOS réalisés simultanément sur le même substrat.

Malheureusement, les essais qu'on a pu effectuer jusqu'à maintenant n'avaient pu donner de résultats satisfaisants à cause d'une contrainte essentielle qui est la nécessité d'une très faible largeur de base entre l'émetteur et le collecteur.

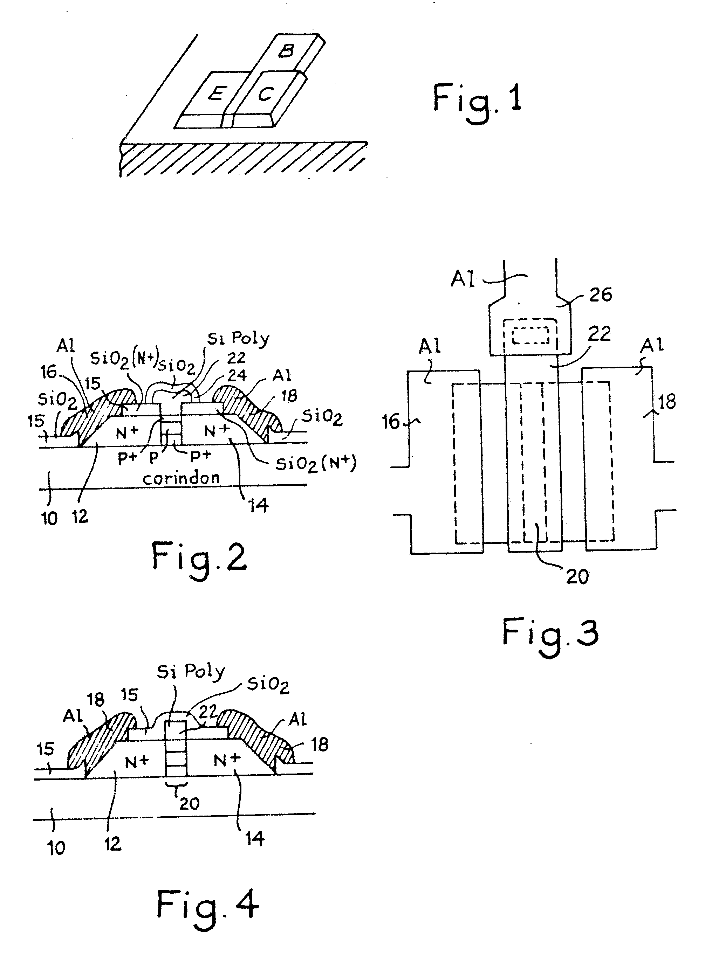

La base doit se présenter sous forme d'une bande très étroite (un à deux unicrons) entre l'émetteur et le collecteur. Il est impossible alors d'établir sur cette bande très étroite un contact métallique d'accès. On prolonge donc la bande par une partie élargie qui n'est pas située entre l'émetteur et le collecteur mais qui est adjacente à ceux-ci. La figure 1 en montre un exemple. Le contact de base peut être formé sur cette partie élargie (les contacts de base, d'émetteur et de collecteur ne sont pas représentés sur la figure 1, mais on voit qu'on a la place de les mettre). Malheureusement, le contact étant rejeté à l'extérieur de la région étroite de base proprement dite, on constante que la résistance d'accès de la base devient considérable compte tenu de la résistivité de la base, de son étroitesse et de sa longueur. Même si on prévoit une partie élargie et un contact de base respectif de chaque côté de la région étroite de base, on constate que la résistance d'accès est beaucoup trop élevée, conduisant à une tension base-émetteur trop importante (plusieurs volts au lieu de 0,8 volts environ pour un transistor classique vertical), et conduisant à une non-uniformité de la densité de courant dans la base, donc dans l'émetteur et le collecteur.

On peut améliorer cette situation, mais de manière encore insuffisante, en prévoyant que la base est dopée fortement dans sa partie supérieure et éventuellement dans sa partie inférieure pour ne laisser qu'un étroit canal central faiblement dopé (seul un faible dopage permet un bon gain en courant du transistor). On trouve malgré tout que la résistance de base est trop grande et que plusieurs volts doivent être appliqués entre base et émetteur pour que le transsitor fonctionne. Ceci est inacceptable dans la mesure où on aura sur le même substrat des transistors MOS qui feront partie du même circuit et qui eux, ne requièrent qu'une excursion maximum de tension de 5 volts entre drain et source.

La présente invention propose donc une amélioration très sensible des performances d'un transistor bipolaire latéral en prévoyant que du silicium polycristallin de faible résistivité est déposé exactement au-dessus de toute la région étroite de base et se prolonge au-delà de cette région étroite pour permettre l'établissement d'un contact métallique d'accès. Ce contact métallique, rejeté à l'extérieur de la région étroite de base proprement dite, ne risque pas de court-circuiter la base et l'une des régions voisines (émetteur ou colecteur); de plus, il transmet facilement un courant à la base grâce au silicium polycristallin de faible résistivité qui joue le rôle d'un conducteur métallique au-dessus de la base sans en présenter l'inconvénient car:

1.) le silicium polycristallin ne risque pas de courtcircuiter deux régions voisines (base et émetteur ou base et collecteur) mais tout au plus, s'il y a chavauchement, de créer des diodes parasites; en fait, il n'y aura même pratiquement pas de telles diodes parasites car le chevauchement pourra être évité de manière certaine contrairement à ce qui se passe dans le cas d'un dépôt d'aluminium ou d'un autre métal,

2.) la faible résistivité du silicium polycristallin permet d'amener uniformément un courant à toutes les parties de la base, avec une tension limitée appliquée entre le contact de base et le contact d'émetteur.

La structure de transistor bipolaire latéral sur isolant selon l'invention comprend donc:

— un substrat isolant, de préférence en corindon,
— une région d'émetteur en silicium dopé, d'un premier type de conductivité,
— une région de collecteur en silicium dopé du premier type de conductivité, séparée de la première par un intervalle étroit,
— une région de base en silicium dopé, d'un second type de conductivité, s'étendant dans l'intervalle étroit entre les régions d'émetteur et de collecteur,

— une couche isolante d'oxyde de silicium s'étendant audessus des parties des régions d'émetteur et de collecteur adjacentes à la région de base, cette couche étant interrompue au-dessus de la région de base,

— une région de silicium polycristallin de faible résistivité, dopé avec une impureté du second type de conductivité, s'étendant audessus de la région de base sous forme d'une bande itroite pouvant reconvier partiellement ladite couche isolante et venant en contact avec la région de base et présentant une extrémite s'éterdant au — delà des rigions d'émetteur et de collecteur permettant l'établissement d'un contact métallique d'accès à cette région de silicium polycristallin,

— des régions de contact d'émetteur, de collecteur et de base, qui sont respectivement des dépôts métalliques sur le silicium dans la région d'émetteur, dans la région de collecteur, et à l'extrémité de la région de silicium polycristallin.

Les régions d'émetteur et de collecteur sont de préférence fortement dopées au moins dans leur partie supérieure.

La région étroite de base est de préférence constituée avec, de bas en haut, une partie inférieure fortement dopée, une partie centrale faiblement ou moyennement dopée, et une partie supérieure fortement dopée en contact avec le silicium polycristallin qui le recouvre. Cette disposition permet de concentrer au milieu de la région de base (dans le sens vertical) la partie utile du transistor.

Pour réaliser ce transistor (NPN ou PNP), un procédé comprend les étapes consistant à:

— déposer sur le substrat isolant une couche de silicium monocristallin d'un type de conductivité A,

— déposer ensuite du silicium polycristallin de faible résistivité, dopé avec une impureté du type de conductivité A, le silicium polycristallin étant en contact dans une région étroite avec le silicium monocristallin,

— doper avec une impureté d'un type de conductivité B opposé au type A, les régions de silicium monocristallin de part et d'autre de la région étroite de silicium polycristallin, jusqu'à obtenir des régions d'émetteur et de collecteur, du type de conductivité B, respectivement de part et d'autre d'une région étroite de silicium monocristallin constituant une région de base au-dessous de la région étroite de silicium polycristallin,

— oxyder les surfaces de silicium,

— ouvrir dans l'oxyde des régions de contact de contact d'émetteur et de collecteur audessus des régions de silicium monocristallin de part et d'autre de la région étroite, et une région de contact de base au-dessus de la région de silicium polycristallin, cette région de contact de base ne mettant à nu aucune partie des régions de silicium monocristallin de type B adjacentes à la région des base,

— déposer des contacts métalliques dans les diverses régions de contact ouvertes, pour constituer respectivement des accès à l'émetteur, au collecteur et à la base du transistor.

Le dépôt de silicium monocristallin se fait par croissance épitaxiale; il est suivi d'une gravure éliminant le silicium tout autour d'ilots individuels (ou caissons) qui correspondent chacun à un transsitor. On prévoit de préférence que la croissance épitaxiale est faite en deux phases, la première correspondant à une première couche à forte concentration d'impuretés du type A et la seconde à une seconde couche à plus faible concentration. On peut aussi effectuer la croissance d'une couche dont on surdope le fond par implantation ionique à forte énergie.

Le silicium polycristallin est fortement dopé avec une impureté du type A pour avoir une faible résistivité et présenter une conductivité de même type que la base proprement dite. Dans le processus de réalisation du transistor, on prévoira, après le dépôt de silicium polycristallin, une cuisson à haute température (par exemple pendant une phase d'oxydation), assurant une redistribution d'impuretés, de sorte que les impuretés du silicium polycristallin auront tendance à migrer vers la région de base qui est au-dessous et à augmenter superficiellement la concentration en impuretés de celle-ci. Cette particularité permet une réduction supplémentaire de l'épaisseur (verticale) de la région de base peu dopée servant effectivement de région de base au transistor.

Deux variantes de procédé sont possibles pour assurer le dopage avec une impureté d'un type de conductivité B des régions d'émetteur et de collecteur situées de part et d'autre de la région étroite de base.

Selon une première possibilité, on dépose, une couche d'oxyde fortement dopé avec une impureté de type de conductivité B au-dessus de la ou les couches de silciium monocristallin déposées sur le substrat; on dépose ensuite éventuellement une autre couche d'oxyde plus épaisse et non dopée, pour empêcher l'exodiffusion, c'est-à-dire l'évaporation des impuretés hors de la couche d'oxyde fortement dopé; on forme ensuite dans les couches d'oxyde une ouverture étroite correspondant à la région de base, et on dépose dans cette ouverture le silicium polycristallin dopé qui vient en contact avec la couche de silicium monocristallin; la cuisson ultérieure à température élevée réalise simultanément une diffusion des impuretés du type A du silicium polycristallin dans la région de base, et une diffusion des impuretés de type B de la couche d'oxyde dans les régions d'émetteur et de collecteur. A la fin de cette étape, les régions d'émetteur et de collecteur, initialement de type A, deviennent de type B, tandis que la région de base est restée de type A, avec un double gradient de concentration entre le haut et le bas.

Dans cette première variante de procédé, on oxyde superficiellement le silicium polycristallin après son dépôt et avant ouverture des régions de contact d'émetteur, de collecteur, et de base.

Selon une autre variante de procédé de fabrication du transistor latéral, on dépose une couche de silicium polycristallin après le dépôt de la ou les couches de silicium monocristallin, on oxyde la couche de silicium polycristallin, on la grave en laissant une bande étroite au-dessus d'une région qui sera la région de base, on dope avec une impureté de type B les régions d'émetteur et de collecteur de part et d'autre de la bande étroite de silicium polycristallin, et enfin on oxyde à nouveau la surface de silicium apparente.

Le dopage des régions d'émetteur et de collecteur est fait de préférence par implantation ionique après gravure du silicium polycristallin, de sorte qu'il y a dopage de type B des régions d'émetteur et de collecteur avec autoalignement par rapport à la région de base recouverte de silicium polycristallin.

Dans cette deuxième variante de procédé, on a également une redistribution d'impuretés par diffusion d'une impureté de type A du silicium polycristallin fortement dopé vers la région de base qui est en-dessous.

D'autres caractéristiques et avantages de l'invention apparaîtront à la lecture de la description détaillée qui suit et qui est faite en référence aux dessins annexés dans lesquels:

— la figure 1 déjà décrite représente un modèle de transistor bipolaire latéral sur isolant qui a été proposé;

— la figure 2 représente en coupe transversale un exemple de structure de transistor selon l'invention;

— la figure 3 représente en vue de dessus la structure du transistor de la figure 2;

— la figure 4 représente en coupe transversale un autre exemple de réalisation de la structure de transistor selon l'invention;

— les figures 5a à 5f représentent un procédé de réalisation du transistor de la figure 2;

— les figures 6a à 6e représentent une variante de procédé de réalisation selon l'invention, conduisant à la structure du transistor de la figure 4.

Sur la figure 2, 10 désigne le substrat isolant qui est une plaquette de corindon (variété de saphir). Cette plaquette porte par exemple plusieurs transistors MOS et plusieurs transistors bipolaires réalisés selon la même technologie. Chaque transistor est réalisé sur un îlot individuel, les îlots individuels étant séparés les uns des autres sur la surface du substrat isolant 10. Un seul îlot avec un transistor bipolaire NPN est représenté sur la figure 2.

Le transistor comporte un émetteur 12 qui est une région de silicium monocristallin dopée de type $N^+$, la concentration de cette région n'étant d'ailleurs pas uniforme et pouvant être plus élevée dans la partie supérieure de la région 12 que dans la partie inférieure. Le collecteur 14 du transistor est constitué de la même manière que l'émetteur et au cours de la même étape de procédé. Le collecteur et l'émetteur sont recouverts partiellement d'une couche 15 d'oxyde de silicium $SiO_2$, et, là où il n'y a pas d'oxyde de silicium, ils sont recouverts d'aluminium constituant des contacts d'accès 16 et 18 respectivement à l'émetteur et au collecteur.

Entre l'émetteur et le collecteur se situe la base du transistor latéral, base qui se présente sous la forme d'une bande étroite, en silicium monocristallin de dopage P et $P^+$. Cette bande étroite 20 est visible aussi sur la figure 3 qui représente une vue de dessus correspondant à la figure 2.

Le dopage de la base pourrait être uniforme et être constitué par un dopage moyen de type P. On préfère cependant prévoir un dopage non-uniforme, avec un double gradient inversé, avec plus précisémment une couche inférieure de type $P^+$, une couche centrale de type P, et une couche supérieure de type $P^+$.

On remarquera que la couche d'oxyde de silicium $SiO_2$ qui recouvre l'émetteur et le collecteur s'arrête exactement au bord de la région de base et ne recouvre par ou presque pas celle-ci. Au-dessus de la région de base non recouverte, on a déposé du silicium polycristallin 22 qui se présente donc aussi sous la forme d'une bande étroite pouvant recouvrir partiellement l'oxyde $SiO_2$ mais venant en contact avec la région de base là où cette couche d'oxyde $SiO_2$ est absente. La couche de silicium polycristallin 22 s'étentd, comme on le voit sur la figure 3, au-delà des régions d'émetteur et le collecteur, c'est-à-dire qu'elle se prolonge en dehors du carré constituant le transistor proprement dit afin que l'on puisse facilement établir un contact métallique d'accès à cette région 22 de silicium polycristallin, malgré sa faible largeur, sans risquer d venir court-circuiter les régions d'émetteur et de collecteur ou leurs contacts 16 et 18.

La couche de silicium polycristallin 22 a une faible résistivité grâve à une forte concentration $P^+$; elle est recouverte ele-même d'une couche d'oxyde de silicium 24.

Un contact de base 26 est donc prévu, par exemple sous forme d'une métallisation d'aluminium recouvrant l'extrémité de la couche de silicium polycristallin en dehors de la région de base proprement dite entre l'émetteur et le collecteur. Ce contact 26 est établi de manière classique en dénudant le silicium polycristallin dans la région du contact et en déposant de l'aluminium au-dessus de la région dénudée.

On n'a pas précisé sur la figure 2 que la couche d'oxyde de silicium recouvrant l'émetteur et le collecteur était de préférence constituée par une double couche d'oxyde, une pre-

mière couche peu épaisse fortement dopée de type N' qui, au cours du processus de farbrication, sert à assurer le dopage des régions d'émetteur et de collecteur, et une deuxième couche d'oxyde, plus épaisse, non dopée, servant à assurer l'isolation voulue et à empêcher l'évaporation des impuretés de type N+ contenues dans la première couche.

On peut préciser aussi tout de suite que la partie supérieure de la région de base, à savoir la partie de silicium monocristallin de type P+, a une concentration supérieure à la partie centrale de type P simplement par suite de la diffusion vers le bas des impuretés contenues dans la couche de silicium polycristallin qui recouvre la région de base.

La structure de transistor bipolaire NPN qui vient d'être décrite serait transposable immédiatement en un transistor PNP, en inversant les types de conductivité de chacune des régions.

A la figure 4 on a représenté une variante de réalisation de l'invention, dans laquelle les éléments identiques sont désignés par les mêmes références, la disposition étant d'ailleurs la même en vue de dessus que celle de la figure 3.

La différence entre la figure 4 et la figure 2 résulte simplement de ce que le silicium polycristallin 22 est, à la figure 4, exactement centré au-dessus de la base, c'est-à-dire qu'il ne présente par de débordement latéral au-dessus d'une couche d'oxyde $SiO_2$. On a donc représenté simplement une couche unique $SiO_2$ recouvrant à la fois l'émetteur, le collecteur et la région de silicium polycristallin 22. Cette couche d'oxyde $SiO_2$ n'est d'ailleurs pas forcément dopée de type N+, contrairement à la figure 2. On verra comment la bande étroite de silicium polycristallin 22, disposée exactement au-dessus de la base, sert à effecteur un alignement en vue du dopage de l'émetteur et du collecteur par implantation ionique, la base étant protégée justement par le silicium polycristallin mis en place avant cette étape d'implantation ionique.

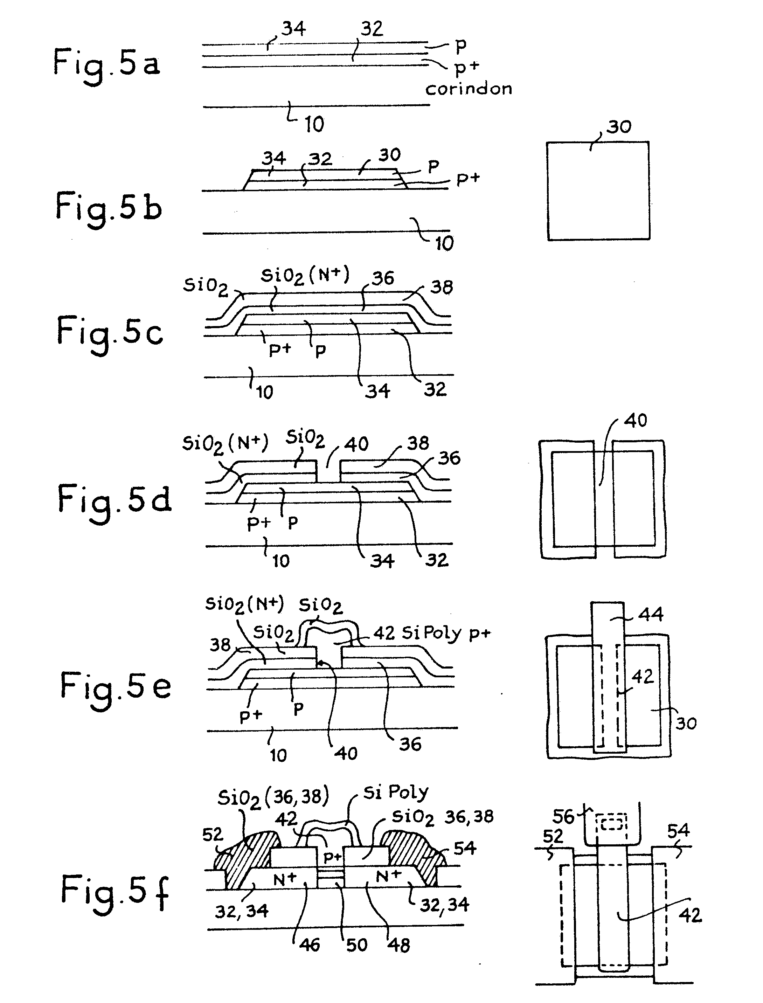

Le procédé de fabrication qui va maintenant être décrit en référence aux figures 5a à 5f permet de réaliser le transistor de la Figure 2.

Dans ce procédé, la première étape consiste à partir d'un substrat isolant de corindon, à faire croître une couche épitaxiale de silicium monocristallin dopé de type P+, et à faire croître ensuite une autre couche épitaxiale identique mais de concentration d'impuretés plus faible, donc de type P, qui servira à constituer la région centrale de la base, à savoir celle dans laquelle s'exercera l'effet transistor proprement dit. La couche inférieure est présente pour réduire l'épaisseur de base effective. On peut aussi faire croître une seule couche épitaxiale dont le fond est surdopé par implantation ionique à haute énergie.

La deuxième étage, représentée à la figure 5b, à la fois en coupe transversale et en vue de dessus à échelle plus réduite, consiste à graver dans les couches de silicium monocristallin des caissons, c'est-à-dire des îlots individuels correspondant chacun à un transistor MOS ou à un transistor NPN. On s'intéresse ici à un transistor NPN et un caisson correspondant 30 a été représenté, incluant une double couche 32, 34 de silicium monocristallin P+ et P, isolée des couches correspondantes d'ilots voisins.

La gravure des caissons est effectuée à l'aide d'un premier masque, par attaque chimique du silicium.

On effectue ensuite un d'oxyde de silicium $SiO_2$ dopé au phosphore, pour établir une couche 36 recouvrant les caissons 30. La couche d'oxyde 36 est fortement dopée car elle servira de source d'impuretés en vue de la diffusion de ces impuretés dans les couches 32 et 34.

Après cette première oxydation réalisant la couche 36, on dépose une autre couche, plus épaisse, d'oxyde de silcium non dopé; cette couche 38 a pour rôle 'empêcher l'exo-diffusion, c'est-à-dire l'évaporation vers le haut des impuretés de type N+ contenues dans la couche 36.

L'étape suivante, représentée à la figure 5d en vue latérale et ven vue de dessus à échelle plus réduite, consiste à ouvrir à l'aide d'un masque approprié, une bande étroite dans les couches d'oxyde de silicium 36 et 38, au-dessus d'une région qui sera la région de base du transistor. L'ouverture étroite réalisée porte la référence 40 et, comme on le voit sur la vue de dessus de la figure 5d, elle sépare complètement en deux parties, respectivement une partie d'émetteur et une partie de collecteur, le caisson individuel correspondant au transistor réalisé.

On dépose ensuite (figure 5e) du silicium polycristallin 42 sur la surface de la structure, et on en élimine la plus grande partie pour ne conserver qu'une bande étroite correspondant à l'ouverture 40 formée à l'étape précédente. Comme on le voit sur la figure 5e, la bande de silicium polycristallin conservée peut être plus large que l'ouverture 40 et par conséquent déborder légèrement sur l'oxyde $SiO_2$ de part et d'autre de l'ouverture 40. L'intérêt de ce débordement vient de ce que l'ouverture 40 est très étroite et qu'il faut superposer précisémment le masque de gravure du silicium polycristallin à l'ouverture 40. Il est donc souhaitable que le second masque corresponde à une largeur légèrement plus grande que le premier afin d'être bien sûr qu'il recouvre la tatalité de l'ouverture 40. Le débordement du silicium polycristallin sur l'oxyde $SiO_2$ n'a d'ailleurs pas d'inconvénient particulier.

On voit, sur la vue de dessus à échelle réduite de la figure 5e, que la bande de silicium polycristallin 42 s'étend non seulement dans l'ouverture 40 du caisson 30 correspondant à un transistor mais légèrement au-delà afin de présenter une extrémité 44 qui servira à établir un contact d'accès à la base que ce contact risque de chevaucher les régions d'émetteur et de collecteur et leurs futurs contacts.

Il faut encore mentionner à propos de l'étape de la figure 5e que le silicium polycristallin est fortement dopé avec une concentration P+, afin d'avoir une faible résistivité, et afin de constituer une source de dopage supplémentaire venant du haut pour la base qui sera située exactement au-dessous de la bande 42. De plus, après le dépôt et la gravure du silicium polycristallin, on oxyde à nouveau les surfaces de silicium dénudées, essentiellement en vue d'éviter que les impuretés de type $P^+$ contenues dans la bande 42 ne s'évaporent vers l'extérieur.

Les étapes suivantes, dont l'aboutissement est représenté à la figure 5f consistent respectivement en une redistribution des impiretés par chauffage de la structure dans un four à température élevée, et en une réalisation des contacts d'accès à la base à l'émetteur et au collecteur du transistor.

En ce qui concerne la redistribution des impuretés, on peut chauffer par exemple la structure à 900°C, et ce chauffage permet d'une part la diffusion des impuretés de type $N^+$ contenues dans la couche 36 vers les régions d'émetteur et de collecteur du transsitor, et d'autre part la diffusion des impuretés du silicium polycristallin vers la région de base. Les impuretés de type $N^+$ ne diffusent pas vers le haut grâce à la couche 38 d'oxyde $SiO_2$ non dopé. Elles diffusent donc vers le bas c'est-à-dire vers le silicium monocristallin qui est initialement dopé en P et $P^+$. La concentration d'impuretés de l'oxyde de la couche 36 est cependant suffisante pour qu'à la fin de l'étape de chauffage la concentration globale d'impuretés dans les couches de silicium monocristallin 32 et 34 soit de type $N^+$. Comme l'oxyde de silicium dopé $N^+$ n'est présent que de part et d'autre de la bande 42 de silicium polycristallin, on définit bien deux régions distinctes de type $N^+$ qui sont une région d'émetteur 46 et une région de collecteur 48. Les impuretés de type N ne diffusent pas au-dessous du silicium polycristallin et il subsiste donc une région de base 50 dans laquelle on trouve toujours les couches superposées $P^+$ et P correspondant aux couches initiales 32 et 34. De plus, uniquement dans la région de base 50 au-dessous de l'ouverture 40, les impuretés de type $P^+$ du silicium polycristallin ont diffusé vers le bas pour réduire l'épaisseur de couche 34 dans laquelle le dopage est P et non $P^+$.

En ce qui concerne la formation des contacts métalliques d'accès à l'émetteur au collecteur et à la base, elle est classique, c'est-à-dire qu'on forme dans l'oxyde de silicium des ouvertures de contact, l'ouverture de contact correspondant à la base étant placée à l'extrémité 44 de la bande de silicium polycristallin 42, puis on dépose le métal aux endroits désirés en l'éliminant ailleurs à l'aide d'un masque approprié. On voit sur la vue de dessus de la figure 5f que la métallisation de base ne risque pas de provoquer un court circuit entre l'émetteur et le collecteur car elle est située à l'extérieur de la région de base proprement dite séparant l'émetteur du collecteur. Sur la figure 5f les métallisations d'émetteur, de collecteur et de base sont respectivement désignées par les références 52, 54 et 56.

Pour terminer la description des figures 5a à 5f, on notera que les étapes du procédé sont exactement les mêmes si l'on veut réaliser un transistor PNP; il faut inverser les types de conductivité à chaque étape.

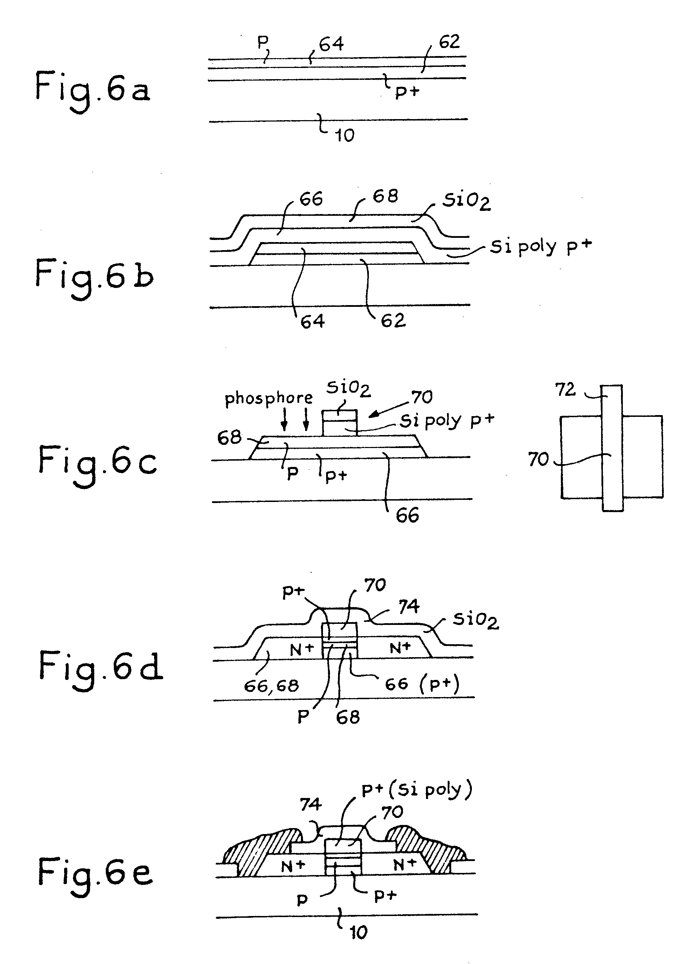

Aux figures 6a à 6e, on a représenté les étapes d'une variante de procédé dans laquelle on cherche à doper l'émetteur et le collecteur par implantation ionique, en profitant de ce que la présence d'une couche de silicium polycristallin au-dessus de la région de base permet de masquer cette région de base au cours de l'implantation. Ceci nécessite bien entendu que la bande étroite de silicium polycristallin gravée selon la forme de la région de base à réaliser soit mise en place avant le dopage de l'émetteur et du collecteur par implantation ionique.

Le procédé décrit maintenant permet d'aboutir au transistor représenté à la figure 4.

La première étape, représentée à la figure 6a, consiste à faire croître une double couche épitaxiale, 62, 64, correspondant respectivement à un dopage $P^+$ et à un dopage P. Commes les couches 32 et 34 de la figure 5a, les couches 62 et 64 permettent de réaliser deux des dopages superposés différents de la base du transistor à réaliser. On peut aussi faire croître une simple couche dont le fond est surdopé par implantation ionique à haute énergie. On grave ensuite dans ces couches 62 et 64 les ilots individuels destinés à contenir chacun un transistor.

On dépose ensuite une couche de silicium polycristallin fortement dopé avec une impureté qui peut être du bore, afin d'obtenir une couche 66 de silicium polycristallin de faible résistivité, de même type que la future région de base du transistor. On dépose sur le silicium polycristallin une couche 68 d'oxyde de silicium $SiO_2$ (figure 6b).

On grave ensuite simultanément à l'aide d'un masque approprié les couches 66 et 68 pour ne laisser sur la structure qu'une bande étroite 70 (vue de dessus de la figure 6c) correspondant à la largeur de la région de base, cette bande étroite s'étendant au moins d'un côté au-delà de l'ilot gravé dans les couches 62 et 64, de manière qu'une extrémité 72 de la bande étroite de silicium polycristallin se situe en dehors des régions d'émetteur et de collecteur définies par les régions de l'ilot séparées par la bande 70. L'extrémité 72 servira, comme l'extrémité 44 de la figure 5e, à établir un contact d'accès à la base.

On remarque que dans ce procédé de réalisation, la largeur de la bande de silicium polycristallin est exactement celle de la base à réaliser, contrairement au procédé des figures 5a à 5f où l'on pouvait prévoir une largeur de silicium polycristallin plus grande en surface que la largeur de la région de base.

Lorsque l'on a gravé la bande étroite de silicium polycristallin recouverte d'oxyde de silicium, on effectue un dopage par implantation ionique d'une impureté, destiné à transformer le silicium monocristallin des couches 66 et 68 en silicium dopé de type $N^+$. De préférence, on utilise une implantation ionique de phosphore en concentration suffisante pour non seulement annuler la concentration initiale P et P¹ des couches 68 et 66, mais encore pour obtenir finalement une concentration N⁺.

A la figure 6d, on voit que l'on a recouvert d'une couche 74 d'oxyde de silicium SiO₂ l'ensemble de la structure, et notamment le silicium monocristallin des couches initiales 66 et 68 et le silicium polycristallin de la bande étroite 70. Sous cette bande étroite subsistent les couches initiales 66 (P⁺) et 68 (P). Cependant, une cuisso ultérieure du dispositif à haute température a effectué une redistribution des impuretés, comme on l'a expliqué en référence à la figure 5f, de sorte que la partie supérieure de la couche initiale 68 de la région de base est également dopée avec une forte concentration p⁺ par suite de la diffusion des impuretés du silicium polycristallin vers le bas donc vers la couche 68.

Les étapes finales de formation des contacts métalliques d'accès à l'émetteur, au collecteur et à la base sont identiques à celles du procédé des figures 5a à 5f et ne seront pas redécrites en détail. On aboutit à la structure représentée à la figure 6e, qui est l'équivalent de la structure initialement décrite en référence à la figure 4a.

Ici encore, on pourra réaliser un transistor PNP en inversant tous les types de concentration d'impuretés par rapport à ce qui a été décrit.

## Revendications

1. Transistor bipolaire latéral sur isolant comprenant:

— un substrat isolant (10);
— une région d'émetteur (12) en silicium dopé, d'un premier type de conductivité;
— une région de collecteur (14) en silicium dopé du premier type e conductivité, séparée de la première par un intervalle étroit;
— une région de base en silicium dopé, d'un second type de conductivité, s'étendant dans l'intervalle étroit entre les régions d'émetteur et de collecteur;
— des régions de contact d'émetteur et de collecteur, qui sont respectivement des dépôts métalliques (16, 18) sur le silicium dans la région d'émetteur et dans la région de collecteur;
— une couche isolante (15) d'oxyde de silicium au dessus des régions d'emetteur et de collecteur dans leurs parties adjacentes à la région de base;

caractérisé en ce que:

— la couche isolante présente une intenuption au dessus de la région de base;
— une région de silicium polycristallin (22) de faible résistivité, dopée avec une impureté du second type de conductivité, s'étend au dessus de la région de base sous forme d'une bande itraite pouvant recouvir partiellement ladite couche isolante et vient en contact avec la région de base et présente une extrémité s'étendant au-delà des régions d'émetteur (12) et de collecteur (14) (22) permettant ainsi l'établissement d'un contact métallique (26) d'accès à cette région de silicium polycristallin.

2. Transistor selon la revendication 1, caractérisé par le fait que les régions d'émetteur et de collecteur sont fortement dopées au moins dans leur partie supérieure.

3. Transistor selon l'une des revendications 1 et 2, caractérisé par le fait que la région de base possédé des gradients inverses de concentration de haut en bas, correspondant respectivement à une partie inférieure fortement dopée, une partie centrale moyennement dopée, et une partie supérieure fortement dopée, cette dernière étant en contact avec le silicium polycristallin.

4. Transistor selon l'une des revendicatons 1 à 3, caractérisé par le fait que le substrat isolant est en corindon.

## Patentansprüche

1. Lateraler bipolarer Transistor auf einem Isolator, mit:

— einem isolierenden Substrat (10),
— einem Emitterbereich (12) aus dotiertem Silicium eines ersten Leitfähigkeitstyps,
— einem Kollektorbereich (14) aus dotiertem Silicium des ersten Leitfähigkeitstyps, der vom ersteren Bereich durch einen schmalen Zwischenraum getrennt ist,
— einem Basisbereich aus dotiertem Silicium eines zweiten Leitfähigkeitstyps, der sich in dem schmalen Zwischenraum zwischen dem Emitter- und dem Kollektorbereich erstreckt,
— Kontaktbereichen am Emitter und am Kollektor, die Metallbeschichtungen (16, 18) auf dem Silicium im Emitterbereich bzw. im Klollektorbereich sind,
— einer Isolierschicht (15) aus Siliciumoxid oberhalb des Emitter- und des Kollektorbereichs in ihren dem Basisbereich benachbarten Zonen,

dadurch gekennzeichnet, daß

— die Isolierschicht eine Unterbrechung oberhalb des Basisbereichs aufweist,
— sich ein Bereich aus polykristallinem Silicium (22) geringen spezifischen Widerstands, dotiert mit einer Unreinheit des zweiten Leitfähigkeitstyps, oberhalb des Basisbereichs in Form eines engen Bandes erstreckt, das teilweise die Isolierschicht bedecken kann und mit dem Basisbereich in Kontakt tritt und ein Ende (22) aufweist, das sich über den Emitter- (12) und den Kollektorbereich (14) hinaus erstreckt und so die Herstellung eines metallischen Zugangskontakts (26) zu diesem Bereich aus polykristallinem Silicium ermöglicht.

2. Transistor nach Anspruch 1, dadurch gekennzeichnet, daß die Emitter- und Kollektorbereiche zumindest in ihrem oberen Teil stark dotiert sind.

3. Transistor nach einem der Ansprüche 1 und 2, dadurch gekennzeichnet, daß der Basisbereich von oben nach unten inverse Konzentrationsgradienten aufweist, die einem stark dotierten unteren Teil, einem mittel dotierten zentralen Teil bzw. einem stark doteirten oberen Teil entsprechen, wobei letzterer mit dem Bereich aus polykristallinem Silicium in Kontakt steht.

4. Transistor nach einem der Ansprüche 1 bis 3, dadurch gekennzeichnet, daß das isolierende Substrat aus Korund ist.

**Claims**

1. A lateral bipolar transistor on a insulating layer, comprising:

— an insulating substrate (10),
— an emitter area (12) made of doped silicium of a first conductivity type,
— a collector area (14) made of doped silicium of the first conductivity type, separated from the first one by a narrow space,
— a base area of doped silicium of the second conductivity type, extending in the narrow space between the emitter and collector areas,
— emitter and collector contact areas, which are respectively metal deposits (16, 18) on the silicium in the emitter area and the collector area,
— an insulating layer (15) of silicium oxide above the sections of the emitter and collector areas adjacent to the base area,

characterized in that

— the insulating layer presents an interruption above the base area,
— an area of polycristalline silicium (22) of low resistivity, doped with an impurity of the second conductivitiy type, extends above the base area in the form of a narrow strip which can partially cover said insulating layer and comes into contact with the base area and presents a terminal zone (22) extending beyond the emitter (12) and collector areas (14), thus permitting the establishment of a metallic contact (26) giving acces to this polycristalline silicium area.

2. A transistor according to claim 1, characterized in that the emitter and collector areas are strongly doped at least in their upper section.

3. A transistor according to one of claims 1 and 2, characterized in that the base area has reversed concentration gradients from top to bottom, corresponding respectively to a strongly doped lower section, a medioum doped central section, and a strongly doped upper section, the latter being in contact with the polycristalline silicium.

4. A transistor according to one of claims 1 to 3, characterized in that the insulating substrate is made of corundum.

Fig. 1

Fig. 2

Fig. 3

Fig. 4

**Fig.5a**

34　　32
p
p+
corindon
10

**Fig.5b**

34　32　30
P
P+
10

30

**Fig.5c**

$SiO_2$　$SiO_2(N^+)$　36　38
P+　P
10　34　32

**Fig.5d**

$SiO_2(N^+)$　$SiO_2$　40　38
36
P+　P
10　34　32

40

**Fig.5e**

$SiO_2(N^+)$　$SiO_2$
$SiO_2$　42 Si Poly p+
38
P+　P
10　40　36

44
42
30

**Fig.5f**

$SiO_2$ (36,38)　Si Poly
42　$SiO_2$　36,38
52　54
P+
N+　N+
32,34　32,34
46　50　48

56
52　54
42

Fig.6a

P   64   62

P+

10

Fig.6b

66   68   SiO2

Si poly p+

64   62

Fig.6c

phosphore   SiO2   70

68   Si poly p+

P   P+

66

72

70

Fig.6d

P+   70   74

SiO2

N+   N+

66,68   66 (P+)

P   68

Fig.6e

P+ (Si poly)

74   70

N+   N+

P   P+

10